# DEMANDE DE BREVET EUROPEEN

(11) **EP 4 557 605 A1**
(43) Date de publication de la demande: **21.05.2025**
(21) Numéro de dépôt: 24209957.0
(22) Date de dépôt: 30.10.2024
(51) Int. Cl.: H02S 20/32, H02S 40/22, H02S 30/20, H10F 19/00

(54) **PANNEAU SOLAIRE**

(30) Priorité: 20.11.2023 EP 23210983
(71) Demandeur: Oksuz, Murat, 4100 Seraing (BE)
(72) Inventeur: Oksuz, Murat, 4100 Seraing (BE)
(74) Mandataire: Gevers Patents

(57) **Abrégé**

La présente invention concerne un panneau solaire (1) comprenant une pluralité de cellules solaires (2) dont chacune est couplée mécaniquement à un réflecteur (3) qui lui est adjacent.

## Description

### Domaine technique

L'invention qui est exposée dans ce document concerne un panneau solaire, un parc ou une centrale solaire et une méthode de production d'énergie au moyen de ce panneau solaire.

### Art antérieur

Pour exploiter l'énergie du soleil, il est bien connu de nos jours d'utiliser des « panneaux solaires », aussi connus sous le nom de panneaux photovoltaïques. Un tel panneau solaire permet en particulier de convertir le rayonnement solaire en énergie électrique. Il comprend un assemblage de « cellules solaires », aussi appelées cellules photovoltaïques, qui sont des composants électroniques aptes à réagir au rayonnement solaire par effet photoélectrique.

Au vu les enjeux environnementaux et climatiques actuels, l'énergie solaire joue un fondamental comme source d'énergie renouvelable pour notre société. À cette fin, l'amélioration du rendement des panneaux solaires est essentielle, et se met typiquement en oeuvre par le développant de semi-conducteurs toujours plus performant pour constituer les cellules solaires.

Les cellules solaires issues de tels développements sont cependant de plus en plus complexes à fabriquer, de sorte qu'une autre approche dans l'amélioration du rendement des panneaux solaires est souhaitée.

Dans ce contexte, la publication de brevet US 7,368,656 B2 présente une cellule solaire pour un panneau générateur solaire d'un véhicule spatial couplée à un réflecteur ayant une extrémité est libre. Les propriétés de flexibilité mécanique du réflecteur sont déterminées de manière à lui permettre, en l'absence de toute pression verticale, de rester en position avec une face supérieure vers l'extérieur, et en réponse à l'application d'une telle pression, de présenter sa face supérieure vers le plan du panneau. La publication de demande de brevet US 2023/0155543 A1 divulgue, quant à elle, un panneau de cellules solaires dont le bord est couplé à une plaque de réflexion présentant un angle qui est modifiable avec une surface du panneau, de façon à empêcher l'ombre de la plaque de réflexion.

### Exposé de l'invention

Un objet de la présente invention est de fournir des moyens pour rendre un panneau solaire plus performant.

À cet effet, l'invention propose un panneau solaire comprenant une pluralité d'ensembles dont chacun comprend :
- une cellule solaire, et
- un réflecteur adjacent et couplé mécaniquement à la cellule solaire, s'étendant selon un plan formant un angle compris entre 50° et 85° avec la cellule solaire.

Chaque tel ensemble permet d'améliorer le rendement du panneau solaire auquel il est intégré. En effet, le réflecteur agencé de façon adjacente à la cellule solaire est orienté de façon à réfléchir sur la cellule solaire un rayonnement solaire qui passerait normalement à côté de cette cellule solaire. Le rayonnement solaire reçu par la cellule solaire est dès lors supérieur à ce qu'il serait sans le réflecteur, et la quantité d'énergie électrique qu'il produit est ainsi accrue. L'angle susdit a été choisi dans le but d'obtenir de bonnes performances à cet égard en considérant qu'une cellule solaire est généralement orientée vers le rayonnement solaire, idéalement perpendiculairement à celui-ci, ou à tout du moins en formant un angle de moins de 30° avec celui-ci.

L'inventeur a déterminé qu'un angle compris entre 65° et 70°, de préférence d'environ 67,5° était préféré. Cet angle tend à maximiser le rendement lorsque la cellule solaire est orientée perpendiculairement au rayonnement solaire. La valeur préférée susdite n'est pas limitative du cadre de l'invention, d'une part vu qu'une amélioration des performances du panneau solaire existe pour des angles entre 50° et 85°, et d'autre part vu que le panneau solaire n'est pas orienté exactement perpendiculairement au rayonnement à tout moment de la journée, l'angle entre le rayonnement solaire et le plan de la cellule solaire étant à prendre en compte pour évaluer en pratique les performances du panneau solaire tel qu'il est bien connu par un homme du métier.

De cette façon, il est fourni des moyens mécaniques compacts et couplés mécaniquement directement à la cellule et/ou au panneau solaire pour accroître les performance de conversion énergique d'un panneau solaire.

Dans le cadre du présent document, un « panneau solaire » correspond à un assemblage de cellules solaires connectées électriquement tel qu'il est connu d'un homme du métier. Toute partie de panneau solaire comprenant une pluralité de cellules solaires connectées électriquement peut donc aussi être assimilée à un panneau solaire au sens de ce document. L'usage de ce terme suppose, dans ce document, que les cellules solaires peuvent être connectées électriquement de façon à rendre le panneau solaire fonctionnel même si cet aspect n'est pas décrit en détails.

Dans le cadre du présent document, le terme « réflecteur » est utilisé pour faire référence à un objet permettant de modifier la trajectoire d'un rayonnement lumineux, typiquement solaire. En particulier, le réflecteur est utilisé dans le cadre de l'invention pour rediriger du rayonnement solaire qui ne devrait normalement pas interagir avec la cellule solaire vers la cellule solaire. Il s'agit typiquement d'un réflecteur optique. Tout type de réflecteur connu qui soit suffisamment rigide selon l'emplacement final du panneau solaire peut être utilisé. Il est par exemple formé d'une plaque en aluminium de 1,0 à 2,0 mm d'épaisseur.

Dans le cadre du présent document, la notion de « couplage mécanique » entre deux éléments fait référence à un maintien mécanique des positions de ces deux éléments l'un par rapport à l'autre. Ce terme inclut la possibilité d'une fixation directe entre ces deux éléments, mais également celle d'une fixation indirecte au moyen d'au moins un élément intermédiaire. Un couplage mécanique entre deux éléments n'exclut pas un possible mouvement relatif entre ces deux éléments.

En particulier, dans le cadre de l'invention, une rotation relative du réflecteur autour d'un axe de jonction entre celui-ci et la cellule solaire (ou, comme introduit ci-après, le cadre de support) est préférée pour ajuster l'orientation du réflecteur par rapport à la cellule et/ou le panneau solaires. Cette ajustement peut être fait de façon manuelle ou être piloté et/ou guidé par des moyens électromécaniques connectés au couplage mécanique.

Le couplage mécanique susdit peut par exemple être mis en oeuvre par une charnière, optionnellement agencée sur une structure encadrant la cellule et/ou le panneau solaires. De façon alternative, le réflecteur peut être totalement fixé par rapport à ces derniers, éventuellement par l'intermédiaire de la structure susdite. Comme le réflecteur est adjacent à la cellule solaire, le couplage mécanique se fait typiquement sans intermédiaire (par exemple, par fixation directe) ou, selon un mode de réalisation préféré, par l'intermédiaire d'un élément de jonction, comme la structure et/ou la charnière susdites, celui-ci étant typiquement de petite taille et servant à la jonction entre la cellule et/ou le panneau solaire et le réflecteur.

Les termes « adjacent et couplé mécaniquement à » peuvent être substitués par « adjoint à », éventuellement par l'intermédiaire d'un élément de jonction (tel que la structure susdite) et/ou une liaison pivot (telle que la charnière susdite).

Dans le cadre de ce document, tel qu'il est connu, l' « angle » entre deux plans de l'espace usuel correspond au plus petit angle entre les directions des vecteurs normaux respectifs à ces plans. Il s'agit donc d'un angle aigu ou droit. Comme le comprendra l'homme du métier, le réflecteur est typiquement orienté radialement extérieurement à partir de la cellule et/ou du panneau solaire. De cette façon, il ne surplombe pas la cellule et/ou le panneau solaire afin de ne pas faire obstacle au rayonnement solaire qui y est naturellement dirigé. L'angle de rotation qui amène physiquement le réflecteur sur la cellule et/ou sur le panneau solaire correspond donc de préférence, en pratique, à l'angle supplémentaire de l'angle susdit.

L'usage, dans ce document, du verbe « comprendre », de ses variantes, et de ses conjugaisons, pour introduire un élément n'exclut pas la présence d'autres éléments que ceux mentionnés. L'usage de l'article indéfini « un », « une », ou de l'article défini « le », « la » ou « l' », pour introduire un élément n'exclut pas la présence d'une pluralité de ces éléments.

Les termes « premier », « deuxième », « troisième », etc. sont, quant à eux, utilisés dans ce document essentiellement pour différencier différents éléments, et ce sans impliquer d'ordre entre ces éléments.

Selon un mode de réalisation, chaque ensemble peut comprendre deux tels réflecteurs couplés mécaniquement à des côtés opposés de la cellule solaire. De préférence, la cellule solaire a une forme rectangulaire et les réflecteurs sont fixés, avec un degré de liberté rotationnel éventuel, sur deux côtés opposés, se faisant face de la cellule solaire.

Ce mode de réalisation permet avantageusement d'accroître la quantité de rayonnement solaire redirigé vers la cellule solaire par rapport à la présence d'un réflecteur unique. L'agencement des réflecteurs au niveau de deux côtés opposés de la cellule solaire permet d'adopter une disposition symétrique des réflecteurs et donc un même angle avec la cellule solaire, ce qui facilite l'orientation de la cellule solaire et/ou des réflecteurs selon le rayonnement solaire. Les côtés de la cellule solaire adjacents aux réflecteurs sont de préférence les côtés les plus longs de la cellule solaire, ce afin d'augmenter le rayonnement solaire redirigé vers la cellule solaire sans nécessiter un réflecteur qui s'étende perpendiculairement à la cellule solaire sur une longue distance et qui risquerait de faire de l'ombre sur la cellule solaire.

L'ensemble pour panneau solaire peut être intégré de multiples façons dans un panneau solaire comme il est décrit ci-après. Des cellules solaires traditionnels d'un panneau solaire peuvent être remplacées par l'ensemble selon l'invention, et/ou un réflecteur de grande taille peut être adjoint à un panneau solaire de telle sorte que les cellules solaires en bord de panneau solaire et les portions voisines de ce réflecteur forment des ensembles selon l'invention. Cette adjonction peut en outre être réalisée de multiples façons comme il est décrit ci-après.

Selon un premier mode de réalisation, le panneau solaire est partitionné en une pluralité de zones qui sont :
- des premières zones occupées par des cellules solaires, et
- des deuxièmes zones vides de cellule solaire.
Comme le panneau solaire comprend une pluralité d'ensembles selon l'invention, plusieurs des cellules solaires sont des cellules solaires de tels ensembles et sont dès lors couplées mécaniquement à au moins un réflecteur.

Ce premier mode de réalisation est avantageux car il propose un panneau solaire dont au moins une cellule solaire est « absente » de sorte qu'elle laisse un emplacement vide de cellule solaire définissant une deuxième zone. Ce panneau solaire converti donc moins de rayonnement solaire en énergie électrique vu qu'il comprend moins de cellules solaires mais il est aussi plus facile et moins coûteux à produire au vu de la complexité technologique sous-jacente à la production des cellules solaires. Le manque en productivité du panneau solaire est compensé de façon avantageuse en prévoyant des cellules solaires d'ensembles de l'invention, qui sont donc couplées mécaniquement à des réflecteurs, typiquement de petites tailles pour ne pas causer d'ombres sur les cellules solaires voisines, ce à tout du moins pour une orientation adéquate du panneau solaire comme décrit ci-avant.

Pour optimiser le rendement du panneau solaire selon l'invention décrit, les cellules solaires peuvent appartenir chacune à un ensemble et donc être chacune couplées mécaniquement à au moins un réflecteur. De façon alternative, afin de simplifier la conception du panneau solaire, seule une partie des cellules solaires peuvent être couplées mécaniquement à un réflecteur formant ainsi un ensemble selon l'invention. Par exemple, elles peuvent être disposées en un nombre limité, par exemple une ou deux, de lignes ou de colonnes, ce qui facilite l'adjonction des réflecteurs, ceux-ci pouvant être formé d'une seule plaque de réflexion adjacente à plusieurs cellules solaires. Le nombre de cellules solaires qui appartiennent à un ensemble représente préférentiellement entre la tiers et la totalité du nombre de cellules solaires du panneau solaire, de préférence au moins la moitié de façon à compenser l'absence de cellules solaires dans les deuxièmes zones.

De préférence, chaque première zone est adjacente à une des deuxièmes zones. Ainsi, le panneau solaire comprend une répartition homogène des cellules solaires et permet une production d'électricité homogène sur le panneau solaire. Cette configuration permet aussi d'éviter un encombrement et des zones d'ombre éventuelles consécutives à un grand nombre de réflecteurs dans une même partie du panneau solaire. Elle facile aussi la mise en oeuvre de la réalisation suivante.

Selon une réalisation préférée du premier mode de réalisation, le réflecteur d'un ensemble dont la cellule solaire occupe une des premières zones surplombe une des deuxièmes zones adjacente à cette dernière. La majorité des réflecteurs, préférentiellement tous les réflecteurs, sont de préférence agencés de cette façon, à l'exception des réflecteurs éventuellement orientés vers l'extérieur du panneau solaire, sur le bord de celui-ci.

Avantageusement, les deuxièmes zones sont utilisées non seulement pour réduire la complexité et le coût de fabrication du panneau solaire, mais aussi et surtout pour permettre un agencement facile et homogène des réflecteurs au sein du panneau solaire, sans causer des zones d'ombre sur d'autres cellules solaires. En effet, comme un réflecteur est orienté radialement extérieurement à partir de la cellule solaire, il surplombe a fortiori la zone voisine à la première zone occupée par cette cellule solaire. Si cette zone voisine est également une première zone, la cellule solaire qui y est présente sera ombragée par le réflecteur, et ne pourra pas atteindre son plein rendement. Prévoir que cette zone voisine soit une deuxième zone permet d'éviter ce défaut tout en allégeant et simplifiant le panneau solaire.

De préférence, les premières et les deuxièmes zones d'un panneau solaire selon ledit premier mode de réalisation sont en nombres égaux ou égaux à 10% près, et de préférence réparties de façon homogène sur le panneau solaire. Ceci facilite l'implémentation de la réalisation préférée susdite ainsi que la configuration pour laquelle tout ou partie des réflecteurs surplombent une deuxième zone.

De préférence, les premières et les deuxièmes zones d'un panneau solaire selon ledit premier mode de réalisation sont agencées de façon régulière et/ou de façon alternée, par exemple en lignes, en colonnes ou en quinconce. Ceci permet d'exacerber les avantages susdits dans l'agencement et la proportion des cellules solaires et des deuxièmes zones.

La réalisation pour laquelle les premières zones sont agencées en lignes ou en colonnes peut faciliter les connexions électriques entre les cellules solaires. Un agencement en quinconce est toutefois préféré dans le cadre de l'invention car il permet d'agencer plusieurs réflecteurs selon plusieurs orientations, et donc vers plusieurs cellules solaires autour de ceux-ci et d'optimiser à la fois de façon énergétique et mécanique la construction en premières et les deuxièmes zones. Ainsi, chaque deuxième zone peut être surplombée par plusieurs réflecteurs dont chacun est adjacent et couplé mécaniquement à une cellule solaire occupant une première zone bordant ladite deuxième zone, de façon à former plusieurs desdits ensembles.

Cet avantage se traduit par exemple dans la réalisation revendiquée selon laquelle, pour chaque deuxième zone, le panneau solaire comprend un nombre de (typiquement 2 à 4) premières zones bordant la deuxième zone en question et au moins ce même nombre de réflecteurs surplombant la deuxième zone et dont chacun est adjacent et couplé mécaniquement à une cellule solaire occupant une des (2 à 4) premières zones, de façon à former ledit nombre desdits ensembles. En d'autres termes, l'espace disponible au sein d'une deuxième zone est exploité pour accroître le rendement de ses premières zones voisines vers lesquelles sont orientés des réflecteurs agencés de façon semblable à des versants de toit.

Un réflecteur surplombant la deuxième zone est ainsi orienté vers chaque première zone bordant la deuxième zone.

De préférence, l'angle α pour chacun des ensembles ainsi formé (c'est-à-dire ainsi associé à une deuxième zone) est compris entre 65° et 70°, et/ou est de préférence est identique. Comme il est mentionné précédemment, ceci optimise le rendement énergétique du panneau tout en simplifiant la construction du panneau solaire.

De préférence, le nombre est de 4 pour une majorité de deuxièmes zones. Compte tenu de l'agencement en quinconce susmentionné, il est ainsi possible d'optimiser le rendement de toutes les cellules solaires sur des premières zones voisines à une deuxième zone de la majorité. Les réflecteurs qui surplombent une deuxième zone de cette majorité sont de préférence agencés selon une forme de toit à quatre versants présentant un faîte. Le faîte correspond ainsi à une arête de recoupement des deux plus grands versants opposés.

Une description alternative de la forme est un prisme triangulaire dont une base repose sur la deuxième zone et dont deux extrémités perpendiculaires à la base sont tronqués selon deux plans inclinés à partir de la base vers un centre de la deuxième zone et formant l'angle avec celle-ci.

Cette réalisation permet de réalise, d'orienter et d'agencer correctement les quatre réflecteurs surplombant les deuxièmes zones de façon remarquablement simple, efficace et solide. Il est par exemple rendu possible de fabriquer en série ces formes dans un matériau réflecteur (par exemple, en aluminium), comme des petites pyramides et des poser et solidariser sur les deuxièmes zones du panneau solaire. La fabrication du panneau est ainsi simple et ne nécessite pas d'orienter les réflecteurs individuellement vu qu'ils sont fournis correctement orientés sous cette forme.

Les réflecteurs peuvent aussi être formés dans une plaque de support du panneau solaire supportant les cellules solaires du panneau solaire. Dans ce cas, les formes susdites peuvent être créées à partir d'une telle plaque épaisse faite de matériau réflecteur (par exemple, aluminium) dans laquelle sont ainsi usinés des cavités correspondant aux premières zones pour placer les cellules solaires. Les formes (constituant les réflecteurs) et la plaque de support sont donc d'une pièce d'un seul tenant, ce qui accroît la solidité du panneau solaire de même que sa résistance dans le temps. Les cellules solaires sont également facile à poser dans les cavités prévues à cet effet et latéralement stables vu qu'elles sont entourées de plusieurs formes prismiques.

L'agencement en quinconce motive l'utilisation de telles formes et facilite la fabrication et le maintien des éléments constitutifs du panneau solaire selon ces deux réalisations pratiques.

De préférence, le panneau solaire comprend un bord formé d'un cadre et une plaque de verre trempé maintenue latéralement par le cadre et supportée par chaque faîte. De façon très avantageuse, les faîtes des formes sont ainsi utilisées pour maintenir une plaque de verre trempé. Des extrémités libres de réflecteurs formant les faîtes peuvent être chanfreinée pour fournir des faîtes d'autant plus efficace à cet effet et/ou pour contenir une matière permettant une solidarisation de la plaque de verre trempé sur les faîtes. La plaque de verre trempé est quant à elle souhaitable dans le cadre de l'invention. Elle joue à la fois un rôle protecteur pour les cellules solaires et les réflecteurs en enfermant ceux-ci préférentiellement entre la plaque de support et la plaque de verre trempé, et accroît sensiblement la résistance du panneau solaire dans le temps. Elle évite que des feuilles et autres éléments transportés par le vent ne se coincent entre les formes et n'obturent les cellules solaires rendant le panneau solaire inefficace.

De préférence, le cadre est aussi formé du matériau réflecteur et présente une face interne orienté vers les cellules solaires qui le bordent de façon à former avec elles des ensembles selon l'invention. Ainsi, le cadre lui-même est utilisé de façon avantageuse pour former des réflecteurs.

Selon un deuxième mode de réalisation, le panneau solaire est tel que les ensembles sont semblables et alignés. Les cellules solaires des ensembles selon l'invention forment une rangée continue. Les réflecteurs sont chacun formés d'une portion d'une même plaque de réflexion, dite « plaque principale de réflexion ».

En d'autres termes, ce deuxième mode de réalisation correspond au cas où une plaque de réflexion est adjacente et couplée mécaniquement à un panneau solaire. Celui-ci peut être traditionnel ou selon ledit premier mode de réalisation. Ce deuxième mode de réalisation présente l'avantage d'être plus simple à mettre en oeuvre et de permettre la redirection d'un rayonnement solaire directement sur un grand nombre de cellules solaires au moyen d'une plaque de réflexion de plus grande dimension sans nécessairement considérer une pluralité de réflecteurs de petite dimension.

Dans le cadre de ce document, le terme « plaque de réflexion » est utilisé de semblablement au terme « réflecteur », de sorte que les considérations au regard du réflecteur s'appliquent à la plaque de réflexion. Deux termes sont utilisés pour différentier plus facilement les réalisations pour lesquelles le réflecteur est adjoint à une cellule solaire de celles pour lesquelles il est adjoint de façon plus globale à un panneau solaire, et donc à plusieurs cellules solaires ensemble. La deuxième réalisation se recoupe de toute façon avec la première vu que tout ou partie d'une plaque de réflexion au voisinage direct d'une cellule solaire est considéré, dans ce document, comme définissant un réflecteur au sens de l'invention.

Une plaque de réflexion peut être constituée d'aluminium et/ou de plastique et/ou d'un matériau réfléchissant connu d'un homme du métier. Elle est prévue avec une épaisseur suffisamment petite pour ne pas alourdir le panneau solaire et suffisamment grande pour résister à des vents modérés ou autres phénomènes météorologiques. Une épaisseur de 1,0 à 2,0 mm est préférée.

De préférence, le panneau solaire selon ledit deuxième mode de réalisation comprend plusieurs rangées successives de cellules solaires semblables qui sont agencées continûment selon une forme rectangulaire ayant une longueur et une largeur plus petite ou égale à la longueur. En particulier, les cellules solaires sont agencées de façon matricielle et connue de l'art antérieur. Les rangées de cellules solaires qui suivent la rangée suscitée des cellules solaires des ensembles selon l'invention ne sont pas nécessairement des parties d'ensembles selon l'invention et peuvent être des cellules solaires traditionnelles, c'est-à-dire sans réflecteur qui leur sont adjoints.

Un cadre de support (ou plus simplement cadre) borde préférentiellement la forme rectangulaire selon laquelle les rangées de cellules solaires sont agencées. La plaque principale de réflexion est alors couplée mécaniquement à un côté du cadre de support, dit « côté principal ». Cette réalisation permet d'adjoindre très simplement la plaque principale de réflexion sur un des bords du panneau solaire en couplant ou fixant mécaniquement celle-ci sur ledit côté du cadre de support.

Le panneau solaire comprend de préférence deux telles plaques principales de réflexion respectivement couplées mécaniquement (et adjointes) à des côtés principaux opposés du cadre de support. Ainsi, plus de rayonnement solaire est dirigé vers les cellules solaires, ce qui accroît leur performance. Les plaques principales de réflexion sont positionnés sur des côtés opposés, permettant une configuration symétrique, avec un même angle par rapport au panneau solaire, en évitant des interférences entre elles, notamment si deux tels panneaux solaires sont placés côte à côte.

De préférence, le ou les côtés principaux du cadre de support correspondent à la longueur de la forme rectangulaire. Auquel cas, la ou les plaques principales de réflexion sont de préférence chacune dimensionnée semblablement à la forme rectangulaire et s'étendent chacune sur tout le côté principal du cadre de support auquel elle est couplée mécaniquement (et adjointe).

Le choix du côté principal du cadre de support correspondant à la longueur de la forme rectangulaire permet à la ou aux plaques principales de réflexion de s'étendre sur le plus long des côtés du cadre de support. Il est ainsi possible de diriger le rayonnement solaire sur un grand nombre de cellules solaires sans que les plaques principales de réflexion ne s'étendent radialement extérieurement trop loin du cadre de support, et donc du panneau solaire, minimisant l'encombrement et l'ombre éventuelle (selon l'orientation du panneau solaire) qu'elles induisent.

Par un « dimensionnement semblable », il est fait référence dans le cadre de ce document à un dimensionnement à 10% près de longueur de côté. L'avantage d'utiliser un dimensionnement semblable de la forme rectangulaire et des plaques principales de support est qu'elles sont susceptible d'être repliées l'une sur l'autre sans dépasser, ce qui est pratique pour ranger le panneau solaire, notamment s'il s'agit d'un panneau solaire portatif d'appoint. En pratique, les plaques principales de réflexion ont par exemple une longueur supérieure de 5,0 à 20 mm à la forme rectangulaire.

Le cadre de support étant rectangulaire, il comprend deux autres côtés, dits « côtés latéraux » et chacun correspondant à la largeur de la forme rectangulaire. De préférence, une plaque de réflexion, appelée « plaque latérale de réflexion », est couplée de façon mécanique (et adjointe) à un des côtés latéraux. La plaque latérale de réflexion est de préférence dimensionnée semblablement à au moins la moitié de la forme rectangulaire et s'étend sur tout le côté latéral. De façon plus préférée, une telle plaque latérale de réflexion est adjointe à chacun desdits côtés latéraux. Cette réalisation est typiquement utilisée pour un panneau solaire isolé pour lequel il est possible de maximiser la quantité de rayonnement solaire dirigée sur les cellules solaires en utilisant trois ou quatre plaques de réflexion, chacune couplée mécaniquement (et adjointe) à un côté distinct du cadre de support.

L'inventeur a toutefois mis en évidence que la ou les plaques latérales de réflexion ne jouent pas un rôle essentiel dans l'amélioration des performances du panneau solaire dans le cas préféré où la longueur de la forme rectangulaire est supérieure ou égale au double de sa largeur. Dans un tel cas, il est plus simple et tout à fait suffisant de prévoir seulement les deux plaques principales de réflexion dimensionnées semblablement à la forme rectangulaire comme décrit ci-avant.

Le deuxième mode de réalisation de l'invention est en particulier avantageux pour des panneaux solaires isolés tels qu'un panneau solaire portatif d'appoint ou un panneau solaire isolé monté sur un suiveur solaire tel que connu d'un homme du métier. De tels panneaux sont préférés selon l'invention même s'il est tout à fait envisageable d'utiliser des panneaux solaires selon l'invention, en particulier selon ledit premier mode de réalisation, sur un toit d'une construction orientée de façon appropriée.

De préférence, chaque plaque de réflexion est couplée mécaniquement sur un côté du cadre de support via une liaison pivot entre ces éléments réalisée par exemple via une ou plusieurs charnières. Auquel cas, chaque plaque de réflexion est maintenue selon l'angle par des moyens de maintien amovibles. Ceux-ci sont par exemple réalisés par un cliquet ou un tendeur. Ce dernier présente l'avantage d'éviter que la plaque de réflexion ne soit maintenue selon l'angle par rapport au panneau solaire de façon trop rigide, ce qui pourrait engendrer des dommages à la liaison pivot, voire à l'ensemble du panneau solaire, en cas de vents ou autres phénomènes météorologiques. En outre, un tendeur est facile à placer et enlever. La plaque de réflexion peut ainsi être repliées sur les rangées de cellules solaires dans une configuration de rangement du panneau solaire. La longueur du tendeur est de préférence essentiellement définie par l'angle.

L'inventeur propose également dans le cadre de ce document une structure de support pour panneau solaire comprenant ledit cadre de support auquel est couplé mécaniquement une ou plusieurs plaques de réflexion comme il est décrit ci-avant, et un fond encadré par le cadre. Le « fond » est par exemple une grille ou une plaque métallique ou plastique ayant les dimensions du cadre de support. Cette structure de support permet avantageusement de supporter des rangées de cellules solaires (ou panneau solaire usuel) en les posant simplement sur le fond, dans le cadre de support. Ainsi, elles sont maintenues dans la structure, laquelle confère une performance améliorée au panneau solaire correspondant grâce à la ou aux plaques de réflexion.

Ces structures de support permettent un nettoyage, une réparation et/ou un remplacement plus aisé de panneaux solaires lorsque les cellules solaires sont endommagées et/ou si leur efficacité peut être améliorée. En effet, elles peuvent être placées définitivement sur un site, par exemple, sur un toit ou sur un suiveur solaire.

L'invention propose aussi une méthode de production d'énergie comprenant les étapes de fournir un panneau solaire selon l'invention, de placer et maintenir (de jour) les cellules solaires des ensembles (de préférence toutes les rangées de cellules solaires) selon une orientation qui soit sensiblement perpendiculaire à un rayonnement solaire.

Les modes de réalisation et les avantages afférant au panneau solaire selon l'invention se transposent mutatis mutandis à la présente méthode. En particulier, la méthode selon l'invention permet une production d'énergie plus performante à partir d'un rayonnement solaire. Le terme « sensiblement perpendiculairement » correspond de préférence à une orientation entre le plan d'extension du panneau solaire et l'axe du rayonnement solaire comprise entre 75° et 105°.

De préférence, l'étape de maintien susdite est réalisé de façon mécanique par un suiveur solaire et/ou manuelle en réorientant les cellules solaires toutes les deux à six heures, par exemple, trois fois par jour.

### Brève description des figures

D'autres caractéristiques et avantages de la présente invention apparaîtront à la lecture de la description détaillée qui suit pour la compréhension de laquelle on se reportera aux figures annexées parmi lesquelles :
- la figure 1 illustre une vue tridimensionnelle du dessus d'un panneau solaire selon ledit deuxième mode de réalisation de l'invention ;
- la figure 2 illustre une vue tridimensionnelle de l'arrière du panneau solaire de la figure 1 agencé sur des moyens mécanique d'orientation ;
- la figure 3 illustre une vue de côté de l'ensemble de la figure 2 dans une configuration repliée et portative ;
- la figure 4 illustre une section médiane du panneau solaire de la figure 1 ;
- la figure 5 illustre une vue tridimensionnelle du dessus d'un panneau solaire selon ledit premier mode de réalisation de l'invention ;
- la figure 6 illustre une vue du dessus d'un autre panneau solaire selon ledit premier mode de réalisation de l'invention ;
- la figure 7 illustre une coupe selon l'axe VII du panneau solaire illustré sur la figure 6 ;
- la figure 8 illustre une coupe selon l'axe VIII du panneau solaire illustré sur la figure 6 ;
- la figure 9 illustre une vue de côté de panneaux solaires selon une autre réalisation de l'invention.

Les dessins de ces figures ne sont pas à l'échelle. Des éléments semblables sont en général dénotés par des références semblables dans les figures. Dans le cadre du présent document, les éléments identiques ou analogues peuvent porter les mêmes références. En outre, la présence de numéros ou lettres de référence aux dessins ne peut être considérée comme limitative, ce notamment lorsque ces numéros ou lettres sont indiqués dans les revendications.

### Description détaillée de modes de réalisation de l'invention

Cette partie du document présente une description détaillée de modes de réalisation préférés de la présente invention. Cette dernière est décrite avec des réalisations particulières et des références à des figures mais l'invention n'est pas limitée par celles-ci. En particulier, les dessins des figures décrites ci-dessous ne sont que schématiques et ne sont pas limitants. Les références L, l, L₁, l₁, L₂, l₂, α, β, γ, Z1 et Z2 représentées sur certains dessins correspondent à des marques ou des repères géométriques essentiellement utilisés pour quantifier et/ou visualiser des propriétés de modes de réalisation de l'invention.

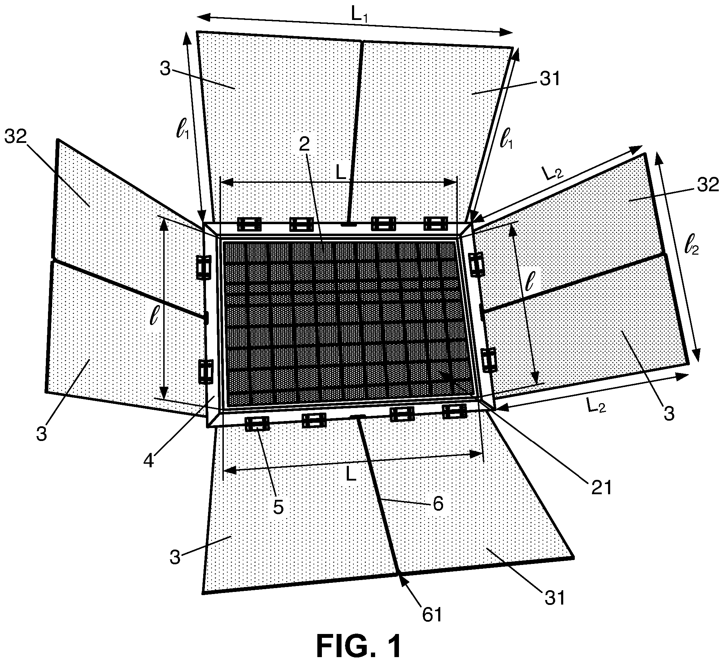

Les figures 1, 2 et 4 illustrent les vues susmentionnées d'un panneau solaire 1 portatif d'appoint selon un mode de réalisation préféré de l'invention dans une configuration d'utilisation.

Le panneau solaire comprend une pluralité de cellules solaires 21 disposées continûment en rangées successives selon une forme rectangulaire de longueur L et de largeur l ≤ L. Les cellules solaires 21 sont notamment reliées électriquement de façon connue d'un homme du métier. Le panneau solaire comprend un cadre de support 4 rectangulaire bordant les cellules solaires. Des plaques de réflexion 31, 32 sont couplées de façon mécanique au cadre de support 4 afin de diriger (et réfléchir) vers les cellules solaires tout ou partie du rayonnement solaire 9 qui les atteindrait.

Le couplage mécanique de chaque plaque de réflexion 31, 32 est réalisé de façon direct, sans intermédiaire, sur le cadre de support 4, au moyen d'une liaison pivot mise en oeuvre par des charnières 5 comme illustré. Chaque côté du cadre de support est associé à une plaque de réflexion 31, 32 dimensionnée de façon à s'étendre sur tout ou presque du côté correspondant. Des plaques de réflexion 31, 32 rectangulaires sont préférées, mais d'autres formes ou des coins arrondis sont envisageables sans se départir du cadre de l'invention.

Plus précisément, deux plaques principales de réflexion 31 semblables sont adjointes sur des côtés opposés du cadre de support 4 associés à la longueur L et deux plaques latérales de réflexion 32 semblables sont adjointes sur des côtés opposés du cadre de support 4 associés à la largeur I. Les deux plaques latérales de réflexion 32 procure un effet technique limité lorsque 2l ≤ L.

Les plaques principales de réflexion 31 sont d'une longueur L₁ ≈ L et d'une largeur l₁ ≈ l. Par exemple : 95% < L₁/L < 105% et 95% < l₁/l < 105%. Lorsque les plaques principales de réflexion 31 sont repliées sur le cadre de support 4 et les cellules solaires 21, elles couvrent totalement ou presque totalement ceux-ci sans dépasser, ce qui est pratique pour ranger le panneau solaire 1 mais aussi afin de protéger les cellules solaires 21 lors du rangement.

Les plaques latérales de réflexion 32 sont d'une longueur L₂ ≥ L/3 et d'une largeur l₂ ≈ l. De façon préférée, L > L₂ et, de façon plus préférée L₂ ≈ L/2, pour limiter l'encombrement spatial vers l'extérieur des plaques latérales de réflexion 32. Par exemple : 95% < 2 L₂/L < 105% et 95% < l₂/l < 105%.

Chaque plaque de réflexion 31, 32 s'étend selon un plan formant un angle α compris entre 50° et 85° avec les cellules solaires 21. En d'autres termes, l'angle α est l'angle entre le plan d'une plaque de réflexion 31, 32 et le plan d'extension des cellules solaires 21 (ou, de façon équivalente, le plan dans lequel s'étend la forme rectangulaire). L'angle α est de préférence compris entre 65° et 70° pour diriger plus de rayonnement solaire 9 vers les cellules solaires 21 lorsqu'elles sont orientées perpendiculairement au rayonnement solaire 9. De préférence, l'angle α est le même pour chacune des plaques de réflexion 31, 32.

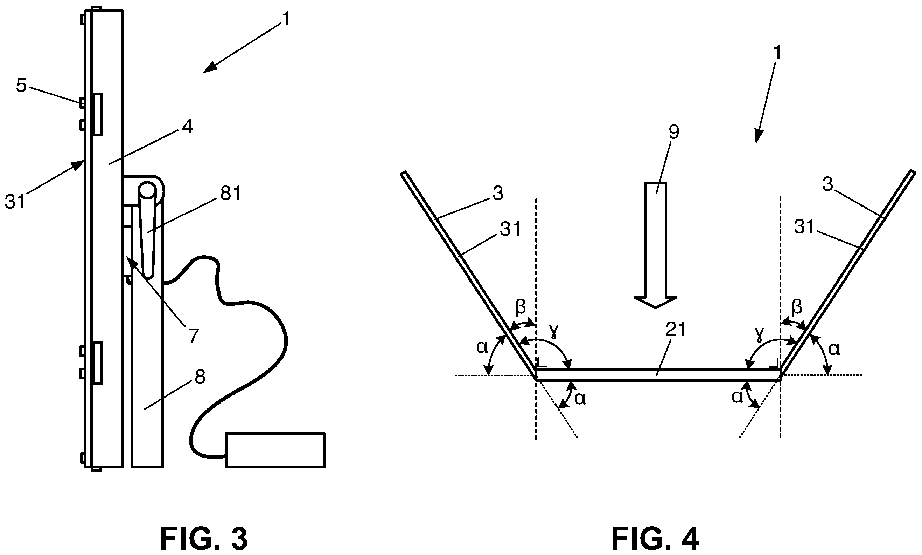

Comme il est illustré sur la section médiane de la figure 4, l'angle α est le plus petit angle entre les deux plans susdits (prolongés en lignes de points sur la figure). L'angle supplémentaire à l'angle α est noté γ = 180° - α. Il correspond à l'angle de rotation qui amène physiquement chaque plaque de réflexion 31, 32 sur les cellules solaires 21. L'angle γ s'écarte radialement vers l'extérieur des cellules solaires 21 d'un angle β = γ - 90° compris entre 5° et 40°, de préférence entre 20° et 25°.

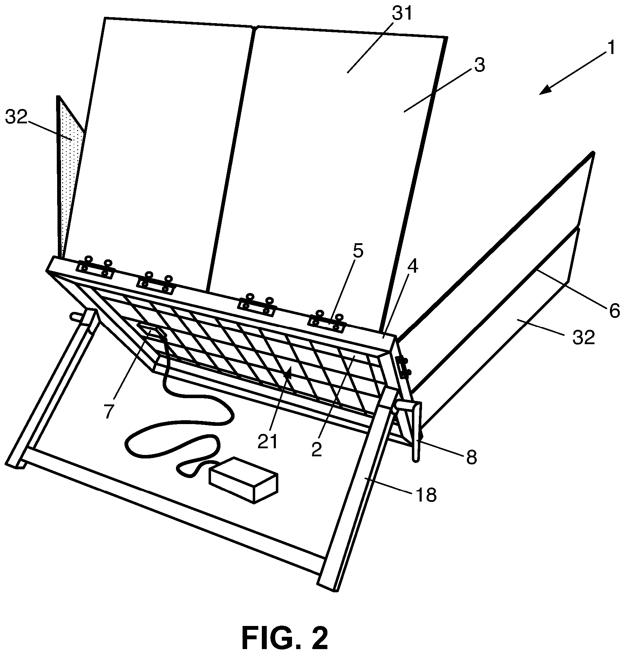

Les plaques de réflexion 31, 32 sont maintenues selon l'angle susdit par des moyens de maintien amovibles 6, typiquement des tendeurs comme illustrés aux figures 1 et 2. Une encoche 61 est prévue en sommet des plaques de réflexion 31, 32 pour y insérer les tendeurs et faciliter leur maintien selon l'angle α prescrit.

Comme il est représenté en figure 2, le cadre de support 4 est monté sur une structure mécanique d'orientation 8 du panneau solaire 1 qui permet par une manette de réglage 81 d'orienter les cellules solaires 21 perpendiculairement par rapport au rayonnement solaire 9 selon le moment de la journée. L'orientation et la direction spatiale du panneau solaire 1 peuvent ainsi être modifiée deux à trois fois par jour pour améliorer ses performances.

De façon connue les cellules solaires sont connectées électriquement à une sortie d'énergie électrique 7 qui peut être reliée à différents dispositifs appropriés par un câble électrique.

La structure mécanique d'orientation 8 est de préférence repliable comme il est visible en figures 2 et 3. En particulier, la figure 3 illustre le panneau solaire 1 portatif d'appoint des figures 1, 2 et 4 dans configuration de rangement. Tant les plaques de réflexion 31, 32 que la structure mécanique d'orientation 8 sont pliées selon un même plan, facilitant ainsi grandement le rangement du panneau solaire.

Les cellules solaires 2, 21 du panneau solaire 1 bordant le cadre de support 4 sont adjacentes et couplées mécaniquement à une des plaques de réflexion 31, 32 de telle sorte que la paire formée par chaque portion des plaques de réflexion 31, 32 adjacente à une telle cellule solaire 2, 21 et cette dernière forment ainsi un ensemble pour panneau solaire selon l'invention.

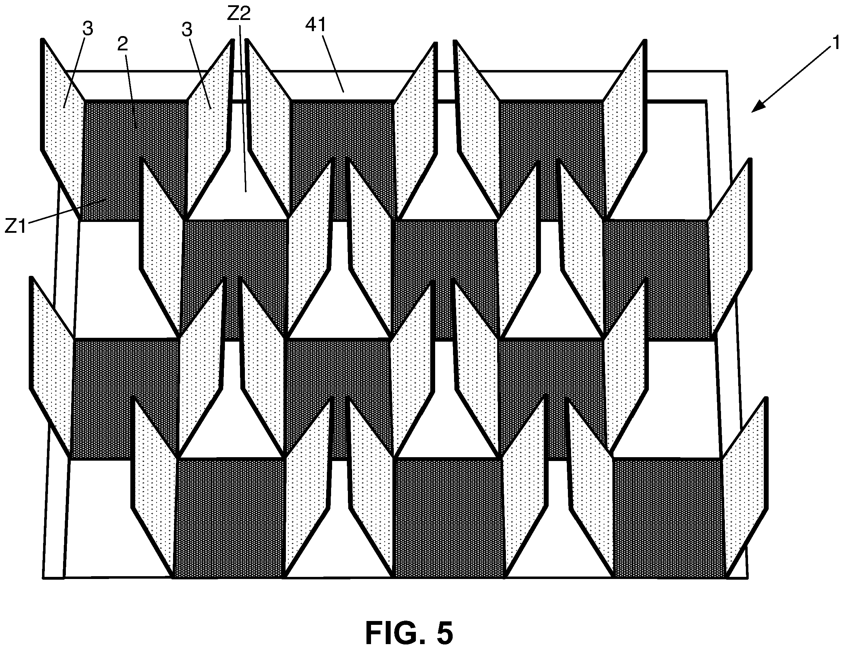

Une mise en oeuvre distincte des figures 1 à 4 de l'ensemble pour panneau solaire selon l'invention est illustrée en figure 5. Il s'agit d'un panneau solaire 1 qui est partitionné en des premières zones Z1 occupées par des cellules solaires 2 et des deuxièmes zones Z2 vides de cellule solaire. Chacune des cellules solaires 2 fait partie d'un ensemble en ce qu'au moins un réflecteur 3 lui est adjoint, et est donc adjacent et couplé mécaniquement à la cellule solaire 2.

Cette adjonction peut se faire par fixation directe ou plus préférentiellement par l'intermédiaire d'un cadre bordant la cellule solaire 2. Dans le cas illustré, deux tels réflecteurs 3 sont adjoints à partir de côtés opposés de la cellule solaire 2.

Les réflecteurs 3 des cellules solaires 2 sont orientés de façon semblables, en rangées, pour limiter les ombres éventuelles qu'ils peuvent causer. Ils sont de petites tailles par exemple, entre 25% et 100% de la surface d'une cellule solaire, de préférence environ 50%. Chacun des réflecteurs s'étend selon un plan formant un angle α compris entre 50° et 85° avec le plan du panneau solaire 1 dans lequel les cellules solaires 2 sont agencées.

De façon avantageuse, chaque première zone Z1 est adjacente à au moins une deuxième zone Z2 de telle sorte que le réflecteur 3 d'une cellule solaire 2 d'une première zone Z1 surplombe une deuxième zone Z2 adjacente qui lui est adjacente. Les premières et deuxièmes zones sont réparties en alternance sur le panneau solaire 1, en quinconce dans l'exemple de la figure 5, celle-ci n'étant pas limitative de la portée de l'invention.

Le panneau solaire 1 peut être bordé par un cadre 41 de façon connue. Les réflecteurs 3 surplombant le cadre peuvent être omis lorsque l'emplacement final du panneau solaire 1 ne permet pas leur présence, faute de place latérale, ou de façon alternative (non représentée), le cadre 41 peut lui-même présenté une face intérieure orientée vers les cellules solaires 2 le bordant, de façon à jouer un rôle de réflecteur, pour autant qu'il soit suffisamment épais et constitué d'un matériau réflecteur comme le comprendra aisément l'homme du métier.

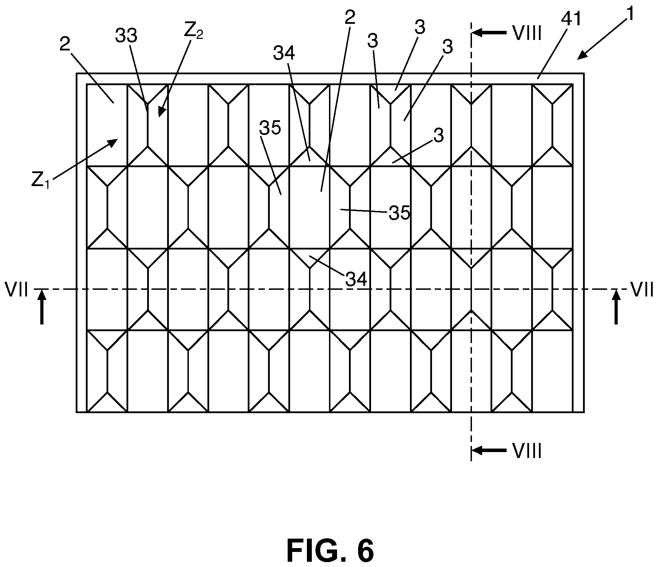

Les figures 6 à 8 illustrent une réalisation apparentée à celle en figure 5 pour laquelle les deux réflecteurs 3, noté 33, surplombant une deuxième zone Z2 sont joints le long d'une ligne supérieure (ou faîte dans la mesure où la forme qui suit s'apparente à celle d'un toit), et tronqué latéralement pour permettre l'agencement de deux autres réflecteurs 3 transverses, noté 34, de telle sorte que les réflecteurs 3 surplombant la deuxième zone Z2 sont ainsi agencés selon une forme 33 de toit à quatre versants présentant ledit faîte. Dans la réalisation illustrée en figure 6, les cellules solaires 2 étant toutes rectangulaires et agencés de la même façon, pour autant que cela soit possible (moyennant le cas d'une deuxième zone Z2 bordant le cadre 41) les réflecteurs 35 (resp. 34) sont distinctement adjacents et couplés mécaniquement à un plus grand (resp. petit) côté d'une cellule solaire 2 voisine de telle sorte à constituer un ensemble pour panneau solaire selon l'invention.

Le motif ainsi constitué par les formes 33 agencées en quinconce permet de répartir le rayonnement solaire selon quatre orientations et deux directions sur les cellules solaires voisines et d'améliorer ainsi le rendement du panneau solaire 1. Il est en outre très facile à constituer comme décrit dans l'exposé de l'invention.

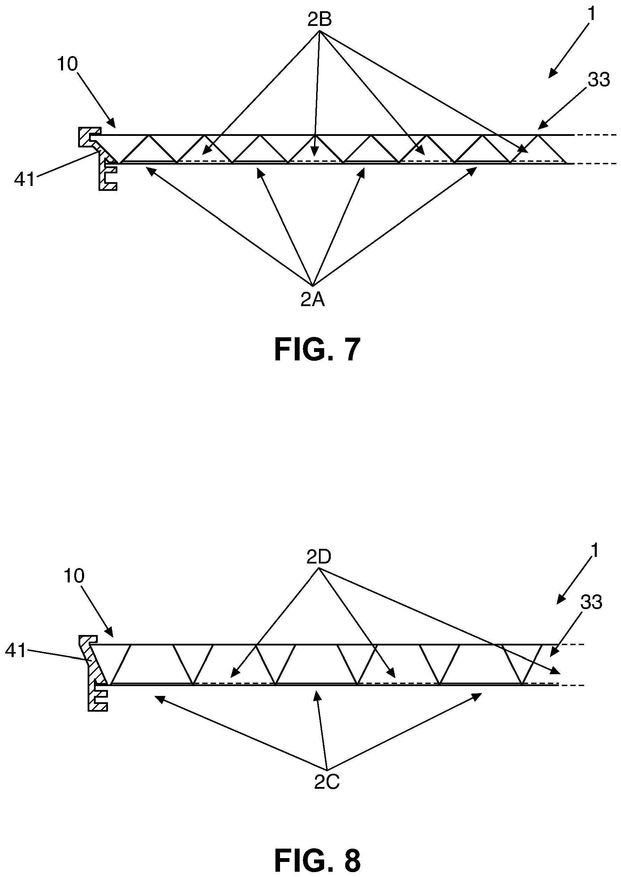

Sur les coupes des figures 7 et 8, les cellules solaires 2A et 2C (resp. 2B et 2D) sont celles visibles en avant-plan, c'est-à-dire en première rangée (resp. en arrière-plan, c'est-à-dire en deuxième rangée) de la coupe. Une plaque constituée de verre trempé 10 (non visible en figure 6) est prévue pour protéger les cellules solaires 2 et les réflecteurs 3, et empêcher que des poussières, des déchets et/ou des végétaux ne se posent et/ou coincent entre les formes 33 en altérant le bon fonctionnement du panneau solaire 1. Avantageusement, il est tiré profit des faîtes de ces formes 33 comme support à la plaque de verre trempé 10. Ceci ressort en particulier de la figure 8. La plaque de verre trempé 10 est maintenue latéralement par le cadre 41, celui-ci ayant alors de préférence un profil adapté à ce maintien tel qu'il ressort des figures 7 et 8. Bien que la plaque de verre trempé 10 puisse limiter le rayonnement solaire atteignant les cellules solaires 2, les avantages que cette plaque induit sont supérieurs à cet inconvénient.

Le panneau solaire 1 peut être placé de façon fixe face à un rayonnement solaire avec une inclinaison de 35° par rapport à un plan d'horizon et incliné de façon transversale de 22,5°. Cette disposition peut également être adoptée pour des panneaux solaires connus pour optimiser leur rendement, en particulier dans un parc ou une centrale solaire.

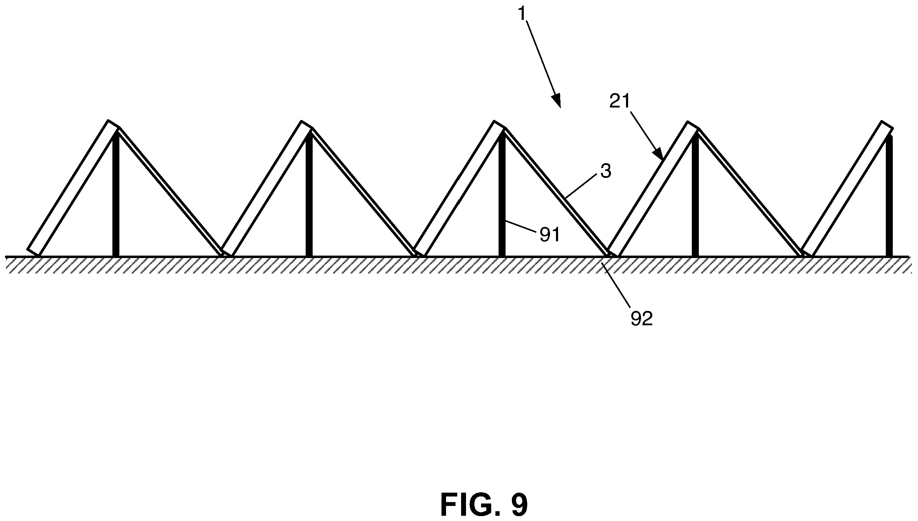

Une autre réalisation de la présente invention est illustrée en figure 9. Il est avantageusement proposé d'exploiter l'invention dans le cadre d'un parc ou d'une centrale de panneaux solaires traditionnels. Par exemple, des panneaux solaires comprenant des cellules solaires 21 sont posés sur un sol 92 et orientés face à un rayonnement solaire en étant supportés par des structures 91 tel qu'il est connu. Dans un tel cas, l'espace entre les panneaux solaires est habituellement perdu. Il est proposé dans le cadre de l'invention d'exploiter cet espace pour y positionner des réflecteurs 3 (ou plaques de réflexion), de telle sorte que tout ou partie des panneaux solaires du parc ou de la centrale deviennent selon l'invention. Dans ce cas, les réflecteurs 3 sont de préférence fixés en extrémités de panneaux solaires, même si l'angle α qui s'ensuit ne maximise pas les performances des panneaux solaires. En effet, en fixant un réflecteur 3 au sommet d'un panneau solaire d'une part, et en pied du panneau solaire derrière d'autre part, le réflecteur 3 est fixé de façon suffisamment stable pour résister au vent, tout en stabilisant l'ensemble du parc ou de la centrale solaire. Les réflecteurs 3 sont de dimensions adaptées à cette usage et prévues pour occuper tous l'espace disponibles entre les panneaux solaires de façon à améliorer au mieux leurs performances.

En d'autres termes, la présente invention prévoit un parc ou une centrale solaire comprenant une séquence de panneaux solaires alignés successivement l'un derrière l'autre, orientés fixement au moins partiellement selon une direction verticale, chaque panneaux solaires 1 au moins deuxième dans la séquence étant selon le deuxième mode de réalisation, et ayant une plaque principale de réflexion 31 (ou de façon équivalente un réflecteur) s'étendant d'un pied de ce panneau solaire 1 jusqu'à un sommet du panneau solaire précédant dans la séquence. Le pied et le sommet sont définis de par l'orientation verticale des panneaux solaires tel qu'il est connu de l'homme du métier. Cette réalisation est également possible en remplaçant les panneaux solaires traditionnels par des panneaux solaires tels que décrit selon le premier mode de réalisation de l'invention.

En résumé, l'invention concerne un ensemble pour panneau solaire 1 formé par une cellule solaire 2 étant couplée mécaniquement à un réflecteur 3 qui lui est adjacent, et plus particulièrement un panneau solaire 1 muni de tels ensembles.

La présente invention a été décrite ci-dessus en relation avec des modes de réalisations spécifiques, qui ont une valeur purement illustrative et ne doivent pas être considérés comme limitatifs. Il apparaîtra directement pour l'homme du métier que l'invention n'est pas limitée aux exemples illustrés ou décrits ci-dessus, et que sa portée est plus largement définie par les revendications ci-après introduites.

## Revendications

1. Panneau solaire (1) comprenant une pluralité d'ensembles dont chacun comprend :
- une cellule solaire (2), et
- un réflecteur (3) adjacent et couplé mécaniquement à la cellule solaire (2), et s'étendant selon un plan formant un angle (α) compris entre 50° et 85° avec la cellule solaire (2).

2. Panneau solaire (1) selon la revendication 1, partitionné en des premières zones (Z1) occupées par des cellules solaires (2, 21) et des deuxièmes zones (Z2) vides de cellule solaire (2, 21), dans lequel le réflecteur (3) d'un ensemble dont la cellule solaire (2) occupe une des premières zones (Z1) surplombe une des deuxièmes zones (Z2) adjacente à cette dernière.

3. Panneau solaire (1) selon la revendication 2, dans lequel les premières (Z1) et deuxièmes (Z2) zones sont agencées de façon régulière et alternée en quinconce.

4. Panneau solaire (1) selon la revendication 3, comprenant, pour chaque deuxième zone (Z2), un nombre de 2 à 4 premières zones (Z1) bordant la deuxième zone (Z2) et au moins ledit nombre de réflecteurs (3) surplombant la deuxième zone (Z2) dont chacun est adjacent et couplé mécaniquement à une cellule solaire (2, 21) occupant une desdites 2 à 4 premières zones (Z1), de façon à former ledit nombre desdits ensembles.

5. Panneau solaire (1) selon la revendication 4, dans lequel l'angle (α) pour chacun des ensembles ainsi formé est identique.

6. Panneau solaire (1) selon la revendication 4 ou 5, dans lequel le nombre est égal à 4 pour une majorité de deuxièmes zones (Z2), les réflecteurs (3) surplombant une deuxième zone (Z2) de cette majorité de deuxièmes zones (Z2) étant agencés selon une forme (33) de toit à quatre versants présentant un faîte.

7. Panneau solaire (1) selon la revendication 6, comprenant un bord formé d'un cadre (41) et une plaque de verre trempé (10) maintenue latéralement par le cadre (41) et supportée par chaque faîte.

8. Panneau solaire (1) selon la revendication 6 ou 7, dans lequel les réflecteurs (3) sont formés dans une plaque de support du panneau solaire supportant les cellules solaires (2, 21).

9. Panneau solaire (1) selon la revendication 1, dans lequel les ensembles sont semblables et alignés, les cellules solaires (2) formant une rangée continue et les réflecteurs (3) étant chacun formés d'une portion d'une même plaque principale de réflexion (31).

10. Panneau solaire (1) selon la revendication 9, comprenant plusieurs rangées successives de cellules solaires (2, 21) semblables agencées continûment selon une forme rectangulaire ayant une longueur (L) et une largeur (l) plus petite ou égale à la longueur (L), et bordée d'un cadre de support (4), la plaque principale de réflexion (31), étant couplée mécaniquement à un côté principal du cadre de support (4).

11. Panneau solaire (1) selon la revendication 10, comprenant une paire de telles plaques principales de réflexion (31) respectivement couplées mécaniquement à des côtés principaux opposés du cadre de support (4), dans lequel le ou les côtés principaux du cadre de support (4) sont associés à la longueur (L) de la forme rectangulaire, et dans lequel la ou les plaques principales de réflexion (31) sont chacune dimensionnée semblablement à la forme rectangulaire et s'étendent chacune sur tout le côté principal auquel elle est couplée mécaniquement, et dans lequel un côté latéral du cadre de support (4) associé à la largeur (l) de la forme rectangulaire est couplé mécaniquement avec une plaque latérale de réflexion (32) dimensionnée semblablement à au moins la moitié de la forme rectangulaire et s'étendant sur tout le côté latéral.

12. Panneau solaire (1) selon la revendication 10 ou 11, consistant en un panneau solaire portatif d'appoint, dans lequel chaque plaque de réflexion (31, 32) est fixée sur un côté du cadre de support (4) par l'intermédiaire d'une liaison pivot (5), et maintenue selon l'angle par des moyens de maintien amovibles (6), de sorte que les plaques de réflexion (31, 32) puissent être repliées sur les rangées de cellules solaires (2, 21) dans une configuration de rangement du panneau solaire (1).

13. Parc ou centrale solaire comprenant une séquence de panneaux solaires alignés successivement l'un derrière l'autre, et orientés fixement au moins partiellement selon une direction verticale, chaque panneaux solaires (1) au moins deuxième dans la séquence étant selon l'une quelconque des revendications 1 à 10, et ayant une plaque principale de réflexion (31) s'étendant d'un pied de ce panneau solaire (1) jusqu'à un sommet du panneau solaire précédant dans la séquence.

14. Méthode de production d'énergie comprenant l'étape de fournir un panneau solaire (1) selon l'une quelconque des revendications 1 à 12, et l'étape de placer et maintenir de jour les cellules solaires (2) des ensembles selon une orientation sensiblement perpendiculairement à un rayonnement solaire (9).

15. Méthode selon la revendication 14, dans laquelle l'étape de maintien est réalisé mécaniquement par un suiveur solaire ou manuellement en réorientant les cellules solaires (2) toutes les deux à six heures.
